# EUROPÄISCHE PATENTSCHRIFT

(11) **EP 1 306 349 B1**
(45) Veröffentlichungstag und Bekanntmachung des Hinweises auf die Patenterteilung: **14.03.2007**
(21) Anmeldenummer: 01125194.9
(22) Anmeldetag: 24.10.2001
(51) Int. Cl.: B81B 3/00, G01K 7/02

(54) **Verfahren zur Herstellung eines Membransensor-Arrays sowie Membransensor-Array**
Method of manufacture of an array of membrane sensors and array of membrane sensors
Procédé de fabrication d'une série de capteurs à membrane et série de capteurs à membrane

(43) Veröffentlichungstag der Anmeldung: 02.05.2003
(73) Patentinhaber: ROBERT BOSCH GMBH, 70442 Stuttgart (DE)
(72) Erfinder: Artmann, Hans, 71106 Magstadt (DE); Pannek, Thorsten, 70176 Stuttgart (DE); Siegel, Robert, 79276 Reute (DE)

(56) Entgegenhaltungen:
- EP-A- 0 490 764
- EP-A- 0 819 935
- WO-A-99/27325
- US-A- 5 231 878
- TABATA O: "Fast-response silicon flow sensor with an on-chip fluid temperature sensing element" IEEE TRANSACTIONS ON ELECTRON DEVICES, MARCH 1986, USA, Bd. ED-33, Nr. 3, Seiten 361-365, XP001053665 ISSN: 0018-9383
- LANG W ET AL: "POROUS SILICON TECHNOLOGY FOR THERMAL SENSORS" SENSORS AND MATERIALS, SCIENTIFIC PUBLISHING DIVISION OF MYU, TOKYO, JP, Bd. 8, Nr. 6, 1996, Seiten 327-344, XP000609408 ISSN: 0914-4935

## Beschreibung

Die Erfindung betrifft ein Verfahren zur Herstellung eines Membransensor-Arrays nach dem Oberbegriff des Anspruchs 1 sowie ein Membransensor-Array nach dem Oberbegriff des Anspruchs 5.

### Stand der Technik

Zur thermischen Entkopplung von unterschiedlichen Bereichen eines Halbleitersensors können Zonen mit bestimmten Wärmeleiteigenschaften vorgesehen werden. So wird beispielsweise in EP- 0 490 764 A1 ein Halbleitersensor mit einem Siliziumsubstrat zum Messen des Durchflusses einer Fluidströmung beschrieben, wobei der Sensor auf einer Seite des Substrates eine erste Zone R1 und eine zweite Zone R2 aufweist und wobei auf der ersten Zone R1 ein Heizelement und auf der zweiten Zone R2 wenigstens ein thermometrisches Element angeordnet ist. Weiter sind die beiden Zonen R1 und R2 durch eine dritte Zone R3 des Substrates voneinander getrennt, wobei die dritte Zone R3 eine Wärmebarriere bildet und aus oxidiertem porösen Silizium besteht. Damit wird bezweckt, dass zwischen den Zonen R1 und R2 eine Rinne angeordnet wird, die aus einem Material besteht, das im Vergleich zu der lateralen Umgebung eine deutlich schlechtere Wärmeleiteigenschaft aufweist.

Auch in der US- 5,231,878 ist ein Halbleitersensor bekannt, bei dem eine Zone aus porösem Siliziumoxid zur thermischen Isolierung von unterschiedlichen Bereichen des Sensors vorgesehen ist. Durch die relativ niedrige thermische Leitfähigkeit des Materials soll damit ein Wärmefluss zwischen den Sensorelementen und dem Substrat verschiedener Bereiche unterbunden werden.

Andererseits sind Verfahren zur Herstellung von Membransensoren mit einem Halbleitermaterialträger bekannt, auf welchem wenigstens ein flächiger Membranbereich als Trägerschicht für Sensorschichten angeordnet ist.

Sofern ein Membransensor-Array mehrere flächige Membranbereiche umfasst, sind diese regelmäßig voneinander durch Stege aus Material mit im Vergleich zur Membran und zu der lateralen Umgebung der Stege deutlich besseren Wärmeleiteigenschaften thermisch entkoppelt.

Die zur Zeit auf dem Markt befindlichen Membransensoren sind zumeist als Dünnschichtmembranen realisiert. Hierzu werden Schichtsysteme in Dicken zwischen einigen 10 nm und einigen Mikrometern auf einem Trägersubstrat abgeschieden und danach das Trägersubstrat in vorgegebenen Bereichen entfernt, um freitragende Membranbereiche zu erhalten. Im Membranzentrum werden dann beispielsweise Sensorelemente angebracht, die durch die freitragende Anordnung der Membran vom umgebenden Trägersubstrat thermisch entkoppelt sind, was für Thermo- und Strömungssensoren erwünscht ist.

Zur Freilegung der Membran können zwei Methoden unterschieden werden:
1. Die Oberflächenmikromechanik (OMM), bei welcher im Allgemeinen eine Opferschicht verwendet wird, die vor der Membranabscheidung auf der Vorderseite eines Trägersubstrates aufgebracht wird. Die Opferschicht wird später von der Vorderseite des Sensors durch "Löseöffnungen" in der Membran entfernt, wodurch eine freitragende Struktur entsteht. Diese oberflächenmikromechanischen Verfahren sind auf Grund der Notwendigkeit von separaten Opferschichten vergleichsweise aufwendig.
2. Die Bulkmikromechanik, bei welcher die Membran durch einen Ätzschritt von der Rückseite des Trägersubstrates freigelegt wird, d.h. indem z.B. durch die vollständige Dicke eines Wafers eine Öffnung geätzt wird.

Für viele Anwendungen sind Arrays (Gruppierungen) von Sensoren erforderlich. Hierzu werden mehrere gleiche Sensoren nebeneinander linear oder zweidimensional angeordnet. Handelt es sich um Thermosensoren, müssen diese durch Wärmesenken voneinander getrennt werden, um eine räumliche Auflösung des Messsignals möglich zu machen.

Für die Herstellung der Wärmesenken gibt es verschiedene Möglichkeiten. Häufig wird eine Schicht aus einem gut wärmeleitenden Material auf der Oberfläche der Membran abgeschieden und strukturiert, so dass die verbleibenden Strukturen des gut wärmeleitenden Materials als Wärmesenken dienen.

Man kann die Membran jedoch auch mit bulkmikromechanischen Prozessen so freilegen, dass zwischen einzelnen Membranbereichen Stege aus Bulkmaterial verbleiben. Bei bulkmikromechanischen Membransensoren wird üblicherweise die Membran von der Rückseite in einem anisotropen Ätzverfahren, beispielsweise mit KOH (Kaliumhydroxid), freigelegt. Hierbei erfordert die Ätzung obgleich ihrer Anisotropie allerdings wesentlich mehr Platz auf der Rückseite des Substrats als für die eigentliche Membranstruktur nötig ist. Dadurch ist mit diesem Prozess die Integrationsdichte begrenzt.

### Aufgabe und Vorteile der Erfindung

Der Erfindung liegt die Aufgabe zu Grunde, die Herstellungskosten von Membransensor-Arrays zu senken und insbesondere Membransensor-Arrays mit verbesserter Integrationsdichte bereit zu stellen, was ebenfalls eine Reduzierung der Herstellungskosten ermöglicht.

Diese Aufgabe wird durch die Merkmale des Anspruchs 1, sowie des Anspruchs 5 gelöst.

Die Erfindung geht zunächst von einem Verfahren zur Herstellung eines Membransensor-Arrays mit einem Halbleitermaterialträger aus, auf welchem mehrere, flächige Membranbereiche als Trägerschicht für Sensorelemente angeordnet sind, und die flächigen Membranbereiche voneinander durch Stege aus Material mit im Vergleich zu den Membranbereichen und zu der lateralen Umgebung der Stege deutlich besseren Wärmeleiteigenschaften thermisch entkoppelt sind. Unter dem Begriff Membranbereich wird im Sinne der Erfindung nicht nur eine freitragende Schicht verstanden, sondern im einfachsten Fall auch eine Schicht, die über einem Volumenbereich angeordnet ist, der eine geringere Wärmeleiteigenschaft als die Stege aufweist. Der Kern der Erfindung liegt nun darin, dass der Halbleitermaterialträger an Stellen, an welchen die Stege zur thermischen Entkopplung ausgebildet werden, eine Maskierung für einen nachfolgenden Schritt zur Erzeugung von porösem Halbleitermaterial erhält, dass das nicht durch Maskierung geschützte Halbleitermaterial porösiziert wird und dass die Membranbereiche daraufhin erzeugt werden, z.B. durch Aufbringen einer durchgehenden Membranschicht auf den Halbleitermaterialträger bzw. die porösizierten Stellen. Durch diese Vorgehensweise wird es möglich, hohe Integrationsdichten von Membransensor-Arrays zu erreichen, deren Einzelsensoren in ausreichender Weise thermisch voneinander entkoppelt sind. Dabei wird die Erkenntnis ausgenutzt, dass die Herstellung von porösem Halbleitermaterial durch eine geeignete Maskierung vergleichsweise feinstrukturell vorgenommen werden kann. Damit lassen sich entsprechend feine Stege herstellen, die dementsprechend dicht nebeneinander angeordnet werden können, was insgesamt eine hohe Dichte von Sensoren eines Arrays erlaubt. Die thermische Entkopplung wird dadurch erhalten, dass die verbleibenden Halbleiterstege im Vergleich zu porösem Halbleitermaterial oder gar, wie weiter unten beschrieben, nach entferntem porösiziertem Halbleitermaterial im Vergleich zu dem dann entstehenden Hohlraum, gegebenenfalls mit Gasfüllung, eine deutlich höhere Wärmeleitfähigkeit besitzen.

In einer besonders bevorzugten Ausgestaltung der Erfindung ist es vorteilhaft, wenn zur Maskierung eine bei der Erzeugung von porösiziertem Halbleitermaterial beständige Schicht, wie z.B. Siliziumoxid, Siliziumnitrit oder Siliziumkarbid bzw. Kombinationen daraus, eingesetzt wird. Dies stellt eine vergleichsweise einfache Möglichkeit der Maskierung dar, bei welcher sich zudem nach Entfernen der Maskierungschicht Wärmesenken in Form der Stege ohne überstehende Bereiche auf Grund eines Unterätzvorgangs realisieren lassen. Allerdings ist es mit dieser Vorgehensweise nicht möglich, freitragende Stege auszubilden.

D.h. die Stege bleiben immer mit dem Bulkmaterial des Halbleitermaterialträgers verbunden.

Um Wärmesenken in Form von freitragenden Stegen mit definierter Breite und Höhe herstellen zu können, wird im Weiteren vorgeschlagen, dass der Halbleitermaterialträger an Stellen, an welchen die Stege zur thermischen Entkopplung ausgebildet werden, als Maskierung eine geeignete Dotierung mit vorgegebener Tiefe erhält, und dass das nicht durch Dotierung ausgezeichnete Halbleitermaterial im Bereich um die Stege porösiziert wird.

Vorzugsweise werden die porösizierten Halbleiterbereiche nach dem Aufbringen der Membranbereiche durch Ätzen entfernt. Auf diese Weise werden insbesondere dann freitragende Stegstrukturen ausgebildet, wenn der Halbleiterbereich um die Stege in einer durchgehenden Wanne porösiziert wurde. Die freitragenden Stege sind ausreichend, um Wärmesenken bereitzustellen, die einer gewünschten thermischen Entkopplung genügen. Das Verfahren hat dabei den Vorteil, dass weder zusätzliche Opferschichten noch weitere, z.B. metallische Schichten für die Ausbildung der Wärmesenken erforderlich sind. Vielmehr kann der "Unterbau" des Membransensor-Arrays unterhalb der Membranbereiche, z.B. in Form einer durchgehenden Membranschicht, vollständig aus dem Halbleitermaterial des Trägers gebildet werden.

Bei einem an sich bekannten Verfahren zur Herstellung von porösem Silizium, wird in der Regel eine elektrochemische Reaktion zwischen Flusssäure und Silizium genutzt, bei der eine schwammartige Struktur im Silizium erzeugt wird. Der Silizium-Halbleiterträger (in der Regel ein Siliziumwafer) muss hierzu gegenüber einem Flusssäureelektrolyt anodisch gepolt sein. Durch elektrochemisches Ätzen des Siliziums (Anodisieren) in beispielsweise einem Gemisch aus Flusssäure/Ethanol wird poröses Silizium durch teilweises Ätzen in die Tiefe erzeugt. Zum Ätzen von Silizium sind Defektelektronen (Löcher) an der Grenzfläche zwischen Silizium und Elektrolyt notwendig, die durch den fließenden Strom bereitgestellt werden. Ist die Stromdichte kleiner als eine kritische Stromdichte j_{KRIT}, so diffundieren Löcher durch das anliegende elektrische Feld an in der Oberfläche liegende Vertiefungen, in denen ein bevorzugtes Ätzen stattfindet. Bei z.B. p-dotiertem Silizium werden die Bereiche zwischen den Vertiefungen bis zu einer minimalen Dicke lateral geätzt, bis durch Quanteneffekte keine Löcher mehr in diese Bereiche eindringen können und der Ätzvorgang gestoppt wird. Auf diese Weise entsteht eine schwammartige Skelettstruktur aus Silizium und freigeätzten Poren. Da bei der Ausbildung der Skelettstruktur der Ätzvorgang nur im Bereich der Porenspitzen stattfindet, bleibt die Schwammstruktur von bereits geätztem Silizium erhalten. Damit bleibt auch die Porengröße in den bereits geätzten Bereichen nahezu unverändert. Die Porengröße ist abhängig von der HF-Konzentration in der Flusssäure, der Dotierung und der Stromdichte und kann von einigen Nanometern bis zu einigen 10 nm betragen. Ebenso ist die Porösizität in einem Bereich von ca. 10 % bis über 90 % einstellbar.

Für die Herstellung von porösem Silizium können verschieden dotierte Substrate verwendet werden. Üblicherweise verwendet man p-dotierte Wafer mit unterschiedlichen Dotierungsgraden. Durch die Dotierung kann die Strukturgröße innerhalb des porösen Siliziums bestimmt werden.

Durch die Erzeugung einer porösen Struktur erhält das Silizium eine große innere Oberfläche und dadurch andere chemische und physikalische Eigenschaften (z.B. andere Ätzrate, Wärmeleitfähigkeit, Wärmekapazität etc.) wie das umgebende Bulk-Silizium. So wird z.B. die Reaktivität deutlich gesteigert, wodurch ein selektives Ätzen von porösem Silizium zum Bulk-Silizium möglich wird.

Die Erzeugung der Stege im Silizium kann dabei wie folgt vorgenommen werden.

Bei Silizium kann man sich die Erkenntnis zu Nutze machen, dass insbesondere p- und n-dotiertes Silizium ein stark unterschiedliches Ätzverhalten aufweisen. Unter den Bedingungen, bei denen im p-dotiertem Silizium poröses Silizium erzeugt werden kann, ist dies in n-dotiertem Silizium nicht oder nur in einem sehr geringem Umfang möglich. Als Maskierungsschicht kann daher beispielsweise eine dünne Schicht an der Oberfläche des p-dotierten Substrats n-umdotiert werden (durch Ionenimplantation oder Diffusion). Das poröse Silizium entsteht bei der elektrochemischen Ätzung nur in den p-dotierten Bereichen. Die Dicke der Maskierungsschicht kann durch Prozessparameter (Dotierungsdosis, Implantationsenergie, nachträgliches Eintreiben von Dotierstoffen) verändert werden. Da die Entstehung von porösem Silizium ein isotroper Prozess ist, wird die Maske dementsprechend unterätzt. Werden die durch Dotierung ausgezeichneten Stegbereiche vollständig unterätzt, entstehen nach Entfernen des porösen Siliziums freitragende Stegstrukturen.

Für das Ätzen des porösen Halbleitermaterials gibt es im Falle von Silizium, insbesondere nach dem Abscheiden von Sensorschichten, im Wesentlichen zwei Möglichkeiten: zum einen mit einer stark verdünnten Kaliumhydroxidlösung (KOH), zum anderen mit Flusssäure (HF). In diesem Fall ist es erforderlich, dass das poröse Silizium noch vor der Aufbringung der Membranbereiche einem Oxidationsschritt unterzogen wird.

Im Weiteren geht die Erfindung von einem Membransensor-Array mit einem Träger aus Halbleitermaterial aus, auf welchem nebeneinanderliegende flächige Membranbereiche als Trägerschicht für Sensorelemente angeordnet sind, die voneinander durch Stege aus Material mit im Vergleich zu den Membranbereichen und zu der lateralen Umgebung der Stege deutlich besseren Wärmeleiteigenschaften thermisch entkoppelt sind, wobei die Stege aus dem Halbleitermaterial des Trägers gebildet sind. Der Kerngedanke bei dieser Ausgestaltung der Erfindung liegt nun darin, dass die Breite der Stege unmittelbar an den Membranbereichen kleiner als 50 µm ist. Dem liegt die Erkenntnis zugrunde, dass derart ausgestaltete Stege in ausreichender Weise die Funktion einer Wärmesenke, beispielsweise, wenn die Stege unterhalb einer durchgehenden Membran angeordnet sind und die Membran in Membranbereiche einteilen, erfüllen.

Um einen einfachen Aufbau eines Membransensor-Arrays zu erhalten, wird im Weiteren vorgeschlagen, dass die Stege ausschließlich aus dem Halbleitermaterial des Trägers gebildet sind.

Setzt man zur Erzeugung der Stege bei beispielsweise einem Siliziumwafer eine Maskierung durch Umdotieren eines p-dotierten Wafers ein, kann die Stegbreite und -dicke durch den Dotierungsprozess einfach eingestellt werden, womit sich der thermische Leitwert in feinfühliger Weise steuern lässt. Genauso lassen sich durch einen solchen Maskierungsprozess in vertikaler Richtung betrachtet dünne Stege herstellen, die den Anforderungen einer Wärmesenke genügen. Es hat sich herausgestellt, dass eine Dicke der Stege von 30 µm aber auch kleiner, bereits ausreichend ist.

Vorzugsweise besteht die Struktur der Wärmesenken aus Stegen, z.B. kreuzweise angeordneten Stegen und einem Rahmenbereich, der mit den Stegen verbunden ist. Um diese Wärmesenkenstruktur zum umgebenden Halbleitermaterial bei einem Prozess, in welchem poröses Halbleitermaterial erzeugt wird, selektiv zu erhalten, ist es bevorzugt, wenn die Stege und der Rahmenbereich entsprechend dotiert sind.

### Zeichnungen

Mehrere Ausführungsbeispiele der Erfindung sind in den Zeichnungen dargestellt und unter Angabe weiterer Vorteile und Einzelheiten näher erläutert. Es zeigen
- Fig. 1: in einem schematischen Schnittbild einen Siliziumwafer mit umdotierten Bereichen als Maskierung für die Herstellung von porösem Silizium,
- Fig. 2: das schematische Schnittbild gemäß Figur 1 mit durch Ätzen entferntem porösem Silizium,
- Fig. 3a und b: eine zu Figur 1 und 2 vergleichbare Anordnung, wobei jedoch für die Herstellung von porösem Silizium eine nachträglich abgeschiedene Maskierungsschicht eingesetzt wird,
- Fig. 4: das schematische Schnittbild eines Siliziumwafers nach einem Ätzprozess von der Waferrückseite,
- Fig. 5a und 5b: ein schematisch dargestelltes Membransensor-Array in der Draufsicht und im Schnitt,
- Fig. 6a und 6b: ein weiteres Membransensor-Array in einem schematischen Schnittbild in unterschiedlichen Prozessstadien und
- Fig. 7: die schematische Draufsicht auf ein weiteres Membransensor-Array.

### Beschreibung der Ausführungsbeispiele

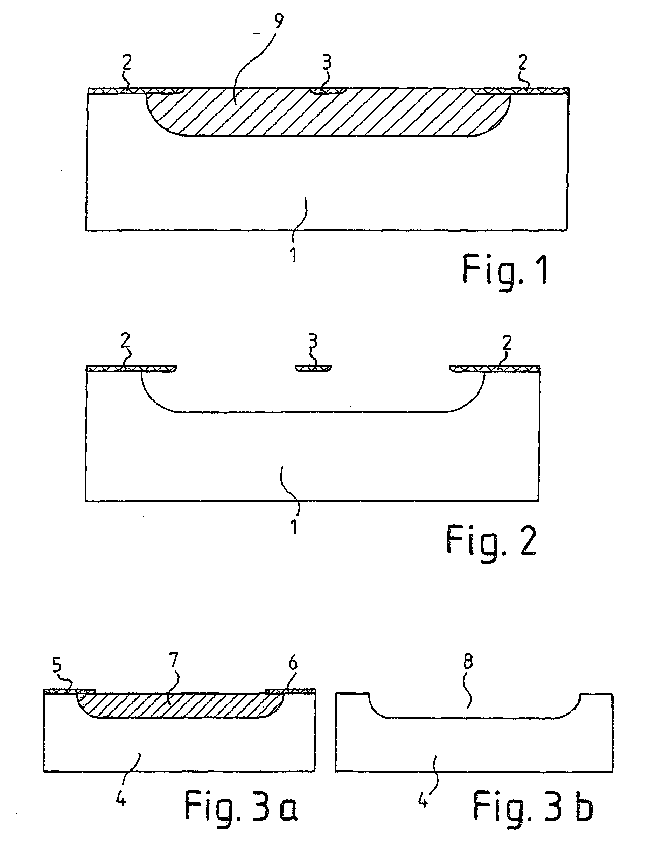

Figur 1 zeigt einen p-dotierten Siliziumwafer 1, der in den Bereichen 2, 3, z.B. durch einen Ionenimplantationsprozess "n" umdotiert wurde. Die n-dotierten Bereiche werden bei der Herstellung von porösem Silizium 9 nicht beeinträchtigt. Auf Grund des isotropen Ätzens bei der Herstellung von porösem Silizium ist in Figur 1 die laterale Unterätzung unter die Bereiche 2, 3 erkennbar. Auf diese Weise wird der Siliziumwafer unter dem Bereich 3 vollständig porösiziert. Nachdem gemäß Figur 2 das porösizierte Silizium 9 in einem selektiven Ätzprozess entfernt wurde, entsteht dementsprechend ein freitragender Steg aus n-dotiertem Silizium.

In Figur 3a ist ein Siliziumwafer 4 dargestellt, auf welchem zur Maskierung eines Bereichs, der porösiziert wurde, eine Maske 5, 6 aus Siliziumoxid und Siliziumnitrit erzeugt wurde. Vor Entfernen des porösen Siliziums 7 kann zunächst die Maske aus Siliziumoxid, Siliziumnitrit oder Siliziumcarbid oder Kombinationen daraus entfernt werden, wodurch gemäß Figur 3b eine "Grube 8" verbleibt, die im Randbereich keine überstehenden "Maskenanteile" wie im Beispiel nach Figur 2 aufweist.

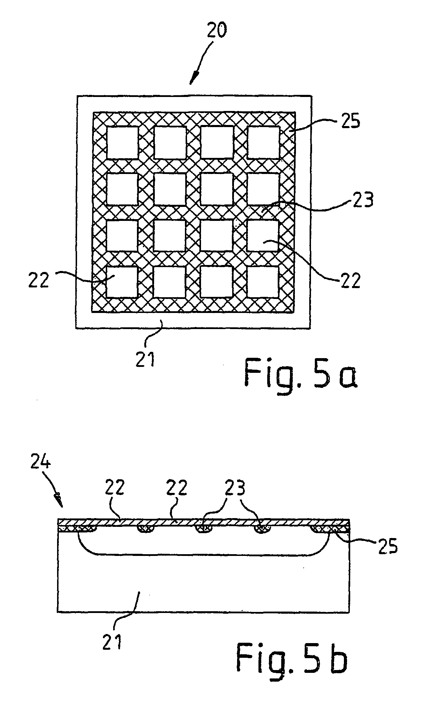

Figur 5a zeigt ein Beispiel eines Membransensor-Arrays 20 in einer schematischen Draufsicht. Auf dem Bulk-Silizium 21 sind freitragende Membranbereiche 22 ausgebildet, (vergleiche Figur 5b) die durch ein Gitter 23 mit Rahmenbereich 25 aus n-dotiertem Silizium, welches als Wärmesenke wirkt, thermisch voneinander entkoppelt sind. Das Gitter 23 und ein Teil des Rahmenbereichs 25 ist freitragend, was die thermische Entkopplung weiter verbessert.

Die Anordnung gemäß 5a und 5b wurde beispielhaft durch einen oberflächenmikromechanischen Prozess, bei welchem als Zwischenschritt poröses Silizium hergestellt wurde, realisiert. Als Maskierung wurde das gitterartige n-dotierte Gebiet 23 mit Rahmenbereich 25 verwendet. Die Dotierung des n-dotierten Gitters 23 und des Rahmens 25 in beispielhaft p-dotiertem Bulk-Silizium 21 wurde durch Ionenimplantation oder durch einen Diffusionsprozess vorgenommen. Bei der Ionenimplantation kann über die Implantationsenergie die Tiefe des implantierten Bereichs eingestellt werden. Die Dicke der Wärmesenke und damit die daraus resultierende Wärmeleitung unter anderem zum Randbereich ist damit in einem weiten Bereich bestimmbar. Bei einem Diffusionsprozess ist die Dotiertiefe mit der Dotierstoffmenge, der Diffusionszeit und der Diffusionstemperatur einstellbar.

Üblicherweise werden mit der Diffusion Dotiertiefen von größer als 10 µm einreicht, während bei einer Ionenimplantation die Tiefe im Bereich von einem bis fünf Mikrometer liegt. Ein Prozess, der als Zwischenschritt die Erzeugung von porösem Silizium vorsieht, kann wie folgt grob gegliedert werden:
a) Herstellung von porösem Silizium
b) gegebenenfalls teilweise Oxidation des porösizierten Siliziums
c) Abscheidung der Membran 24 (siehe Figur 5b)
d) Abscheidung und Strukturierung von Sensorschichten (nicht dargestellt in den Figuren 5a und 5b)
e) Passivierung der Membran
f) Erzeugung von Öffnungen in der Membran (nicht dargestellt)
g) Entfernen des porösen Siliziums bzw. des oxidierten porösen Siliziums.

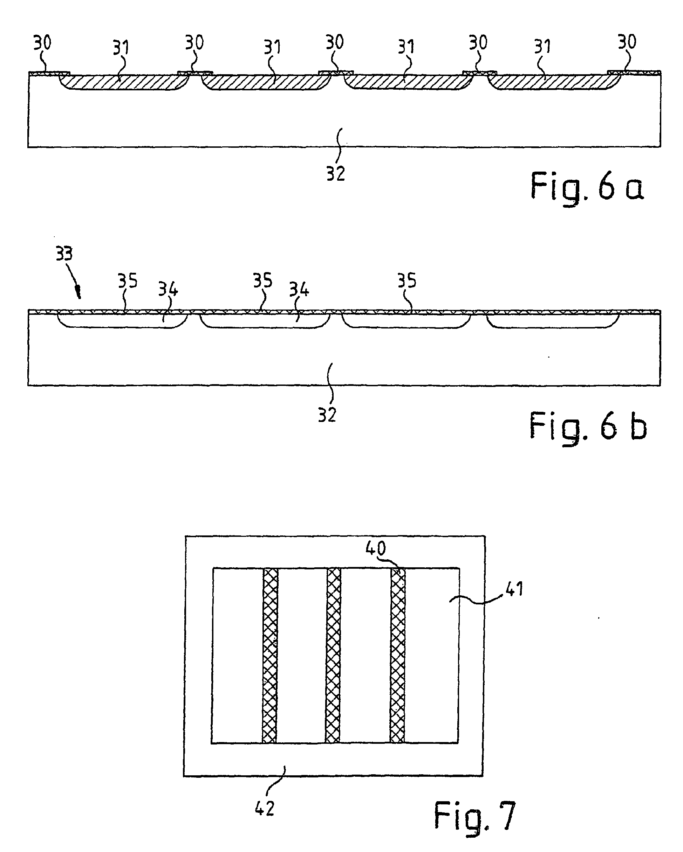

Anstatt der Verwendung einer n-dotierten Maskierung kann eine Maskierungsschicht, wie beispielsweise eine Siliziumoxid/Siliziumnitritschicht 30 (vergleiche Figur 6a), mit ausreichender Dicke verwendet werden. Bei der Erzeugung des porösen Siliziums wird die Maskierung in gleicher Weise wie eine n-dotierte Maskierung auf Grund des isotropen Ätzvorgangs lateral unterätzt. In Figur 6a sind die porösizierten Bereiche 31, die in einem Siliziumwafer 32 ausgebildet sind, mit einer deutlichen Unterätzung unter die Maskierung 30 abgebildet. Nach der lokalen Herstellung von porösem Silizium wird die Maskierung 30 entfernt und nach einer eventuellen Oxidation des porösen Siliziums die Sensormembran 33 (siehe Figur 6b) abgeschieden. Nach der Erzeugung von Sensorelementen (nicht dargestellt) wird das gegebenenfalls oxidierte poröse Silizium durch entsprechende Öffnungen in der Membran 33 von der Vorderseite entfernt. Für eine einfachere Anwendung kann das poröse oder gegebenenfalls oxidierte poröse Silizium 31 auch belassen werden, wodurch keine Gruben 34 (vergleiche Figur 6b) entstehen. Auf Grund seiner um etwa den Faktor 100 reduzierten Wärmeleitfähigkeit ist eine thermische Entkopplung auch beim Belassen des porösen gegebenenfalls oxidierten porösen Siliziums gewährleistet. Die Güte im Hinblick auf die Wärmeleitfähigkeit einer mit Luft, Vakuum oder Füllgas beaufschlagten Grube 34 wird jedoch nicht erreicht.

Durch die erfindungsgemäße Vorgehensweise lassen sich Membransensoren realisieren, bei welchen der Abstand zwischen den einzelnen Membranbereichen 35 auf ein Minimum von ca. 20 bis 50 µm reduziert werden kann.

Die Ausführung von Membransensor-Arrays ist nicht auf Gitterstrukturen begrenzt. Andere frei wählbare Formen von Wärmesenken sind denkbar. Figur 7 zeigt beispielsweise eine Ausführungsform mit Stegen 40 als Wärmesenken in Linienform zur Entkopplung von freitragenden Membranbereichen 41 innerhalb eines Silizium-Bulkmaterials 42.

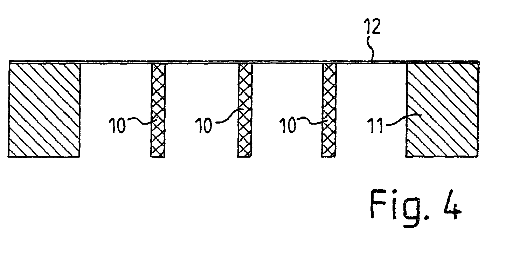

Im Beispiel gemäß Figur 4 wurden Stege 10 als Wärmesenken durch einen anisotropen Plasmaätzprozess von der Rückseite eines Siliziumwafers 11 erzeugt. Die Stege 10 sind freitragend. Auf der Membran 12 können zwischen den Stegen 10 Sensorelemente angeordnet werden, die auf Grund der als Wärmesenken wirkenden Stege 10 thermisch voneinander entkoppelt sind.

## Patentansprüche

1. Verfahren zur Herstellung eines Membransensor-Arrays (20) mit einem Halbleitermaterialträger (1, 4, 11, 21, 32, 42), auf welchem mehrere flächige Membranbereiche (22, 35, 41) als Trägerschicht für Sensorelemente angeordnet sind, und die flächigen Membranbereiche (22, 35, 41) voneinander durch Stege (23, 40) aus Material mit im Vergleich zu den Membranbereichen (22, 35, 41) und zu der lateralen Umgebung der Stege (23, 40) deutlich besseren Wärmeleiteigenschaften thermisch entkoppelt sind, wobei zunächst der Halbleitermaterialträger (1, 4, 11, 21, 32, 42) an Stellen, an welchen die Stege (23, 40) zur thermischen Entkopplung ausgebildet werden, eine Maskierung für einen nachfolgenden Schritt zur Erzeugung von porösem Halbleitermaterial erhält, dass das nicht durch Maskierung geschützte Halbleitermaterial porösiziert wird, und dass die Membranbereiche daraufhin erzeugt werden, **dadurch gekennzeichnet, dass** die Stege (23, 40) unmittelbar an den Membranbereichen mit einer Breite kleiner als 50 µm ausgebildet werden.

2. Verfahren nach Anspruch 1, **dadurch gekennzeichnet, dass** zur Maskierung eine bei der Erzeugung von porösiziertem Halbleitermaterial beständige Schicht (5, 6, 30), wie z.B. Siliziumoxid, Siliziumnitrid oder Siliziumkarbit bzw. Kombinationen daraus, eingesetzt wird.

3. Verfahren nach einem der vorhergehenden Ansprüche, **dadurch gekennzeichnet, dass** der Halbleitermaterialträger (1, 4, 11, 21, 32, 42) an Stellen, an welchen die Stege (23, 40) zur thermischen Entkopplung ausgebildet werden, als Maskierung eine geeignete Dotierung mit vorgegebener Tiefe erhält, und dass das nicht durch Dotierung ausgezeichnete Halbleitermaterial im Bereich um die Stege porösiziert wird.

4. Verfahren nach einem der vorhergehenden Ansprüche, **dadurch gekennzeichnet, dass** die porösizierten Halbleiterbereiche nach Aufbringen der Membranbereiche (22, 35, 41) durch Ätzen entfernt werden.

5. Membransensor-Array (20) mit einem Träger (21) aus Halbleitermaterial, auf welchem nebeneinander liegende flächige Membranbereiche (22) als Trägerschicht für Sensorelemente angeordnet sind, die voneinander durch Stege (23) aus Material mit im Vergleich zu den Membranbereichen (22) und zu der lateralen Umgebung der Stege (23) deutlich besseren Wärmeleiteigenschaften thermisch entkoppelt sind, wobei die Stege (23) aus dem Halbleitermaterial des Trägers gebildet sind, **dadurch gekennzeichnet, dass** die Breite der Stege unmittelbar an den Membranbereichen kleiner als 50 µm ist.

6. Membransensor-Array nach Anspruch 5, **dadurch gekennzeichnet, dass** die Stege (23) ausschließlich aus dem Halbleitermaterial des Trägers gebildet sind.

7. Membransensor-Array nach Anspruch 5 oder 6, **dadurch gekennzeichnet, dass** die Stege (23) unter den Membranbereichen (22) freitragend angeordnet sind.

8. Membransensor-Array nach einem der vorhergehenden Ansprüche 5 bis 7, **dadurch gekennzeichnet, dass** die Dicke der Stege (23) kleiner als 30 um ist.

9. Membransensor-Array nach einem der vorhergehenden Ansprüche 5 bis 8, **dadurch gekennzeichnet, dass** die Membranbereiche (22) eine durchgehende Membran (24) bilden.

10. Membransensor-Array nach einem der vorhergehenden Ansprüche 5 bis 9, **dadurch gekennzeichnet, dass** die Stege (23) und ein Rahmenbereich (25) um die Stege im Vergleich zum verbleibenden Halbleitermaterial bevorzugt dotiert sind.

## Claims

1. Method for producing a membrane sensor array (20) comprising a semiconductor material carrier (1, 4, 11, 21, 32, 42), on which are arranged a plurality of areal membrane regions (22, 35, 41) as carrier layer for sensor elements, and the areal membrane regions (22, 35, 41) are thermally decoupled from one another by webs (23, 40) made of material having significantly better thermal conduction properties in comparison with the membrane regions (22, 35, 41) and the lateral surroundings of the webs (23, 40), in which case firstly the semiconductor material carrier (1, 4, 11, 21, 32, 42) receives, at locations at which the webs (23, 40) are formed for thermal decoupling, a masking for a subsequent step for producing porous semiconductor material, the semiconductor material not protected by masking is porositized, and the membrane regions are thereupon produced, **characterized in that** the webs (23, 40) are formed directly at the membrane regions with a width of less than 50 µm.

2. Method according to Claim 1, **characterized in that** a layer (5, 6, 30) that is resistant during the production of porositized semiconductor material, such as e.g. silicon oxide, silicon nitride, or silicon carbide or combinations thereof, is used for masking.

3. Method according to one of the preceding claims, **characterized in that** the semiconductor material carrier (1, 4, 11, 21, 32, 42) receives, at locations at which the webs (23, 40) are formed for thermal decoupling, a suitable doping with a predetermined depth as masking, and **in that** the semiconductor material not distinguished by doping is porositized in the region around the webs.

4. Method according to one of the preceding claims, **characterized in that** the porositized semiconductor regions are removed by etching after the application of the membrane regions (22, 35, 41).

5. Method sensor array (20) comprising a carrier (21) made of semiconductor material, on which are arranged areal membrane regions (22) lying alongside one another as carrier layer for sensor elements, which are thermally decoupled from one another by webs (23) made of material having significantly better thermal conduction properties in comparison with the membrane regions (22) and the lateral surroundings of the web (23), the webs (23) being formed from the semiconductor material of the carrier, **characterized in that** the width of the webs directly at the membrane regions is less than 50 µm.

6. Membrane sensor array according to Claim 5, **characterized in that** the webs (22) are formed exclusively from the semiconductor material of the carrier.

7. Membrane sensor array according to Claim 5 or 6, **characterized in that** the webs (23) are arranged in self-supporting fashion below the membrane region (22).

8. Membrane sensor array according to one of the preceding Claims 5 to 7, **characterized in that** the thickness of the webs (23) is less than 30 µm.

9. Membrane sensor array according to one of the preceding Claims 5 to 8, **characterized in that** the membrane regions (22) form a continuous membrane (24).

10. Membrane sensor array according to one of the preceding Claims 5 to 9, **characterized in that** the webs (23) and a frame region (25) around the webs are preferably doped in comparison with the remaining semiconductor material.

## Revendications

1. Procédé de fabrication d'un réseau de capteurs à membrane (20) avec un support en matériau semi-conducteur (1, 4, 11, 21, 32, 42) sur lequel on dispose comme couche porteuse d'éléments capteurs, plusieurs zones à membrane (22, 35, 41) plates, désaccouplées thermiquement les unes des autres par des barrettes (23, 40) en un matériau présentant par rapport aux zones à membrane (22, 35, 41) et par rapport à l'environnement latéral des barrettes, de meilleures propriétés de conduction de la chaleur, puis le support en matériau semi-conducteur (1, 4, 11, 21, 32, 42), aux endroits où les barrettes (23, 40) sont réalisées pour produire le désaccouplement thermique, reçoit un masquage prévu pour une étape suivante de production d'un matériau semi-conducteur poreux, faisant que le matériau semi-conducteur qui n'est pas protégé par le masquage devient poreux pour ainsi réaliser les zones à membrane,
**caractérisé en ce que**
les barrettes (23, 40) sont réalisées directement sur les zones à membrane avec une largeur inférieure à 50 µm.

2. Procédé selon la revendication 1,
**caractérisé en ce que**
pour le masquage on utilise, quand on réalise le matériau semi-conducteur rendu poreux, une couche résistante (5, 6, 30) faite par exemple d'oxyde de silicium, de nitrure de silicium, de carbure de silicium ou d'une combinaison de ceux-ci.

3. Procédé selon la revendication 1 ou 2,
**caractérisé en ce que**
le support en matériau semi-conducteur (1, 4, 11, 21, 32, 42), reçoit comme masquage, aux endroits où les barrettes (23, 40) sont réalisées pour produire le désaccouplement thermique, un dopage approprié d'une profondeur prédéfinie, de sorte que le matériau semi-conducteur qui ne reçoit pas un dopage devient poreux dans la zone autour des barrettes.

4. Procédé selon une des revendications précédentes,
**caractérisé en ce que**
les zones semi-conductrices rendues poreuses sont éliminées par attaque chimique après réalisation des zones à membrane (22, 35, 41).

5. Réseau de capteurs à membrane (20) avec un support (21) en matériau semi-conducteur sur lequel, on dispose comme couche porteuse d'éléments capteurs, plusieurs zones à membrane (22) plates, désaccouplées thermiquement les unes des autres par des barrettes (23) faites d'un matériau présentant par rapport aux zones à membrane (22) et par rapport à l'environnement latéral des barrettes (23), de meilleures propriétés de conduction de la chaleur, ces barrettes étant constituées par le matériau semi-conducteur du support,
**caractérisée en ce que**
la largeur des barrettes situées directement sur les zones à membrane est inférieure à 50 µm.

6. Série de capteurs à membrane selon la revendication 5,
**caractérisée en ce que**
les barrettes (23) sont constituées exclusivement du matériau conducteur du support.

7. Série de capteurs à membrane selon la revendication 5 ou 6,
**caractérisée en ce que**
les barrettes (23) font saillie en dessous des zones à membrane (22).

8. Série de capteurs à membrane selon une des revendications 5 à 7,
**caractérisée en ce que**
l'épaisseur des barrettes (23) est inférieure à 30 µm.

9. Série de capteurs à membrane selon une des revendications 5 à 8,
**caractérisée en ce que**
les zones à membrane (22) forment une membrane continue (24).

10. Série de capteurs à membrane selon une des revendications 5 à 9,
**caractérisée en ce que**
les barrettes (23) ainsi qu'une zone de cadre (25) autour des barrettes sont dopées de manière préférentielle, comparativement au matériau semi-conducteur subsistant.
